# EUROPÄISCHE PATENTANMELDUNG

(11) **EP 4 326 009 A1**
(43) Veröffentlichungstag der Anmeldung: **21.02.2024**
(21) Anmeldenummer: 22191239.7
(22) Anmeldetag: 19.08.2022
(51) Int. Cl.: H05K 1/02, H05K 7/14, F24H 1/00

(54) **ANORDNUNG ZUR LÖSBAREN BEFESTIGUNG EINER GEDRUCKTEN SCHALTUNG AN EINER MONTAGEBASIS SOWIE HEIZKARTUSCHE FÜR EINEN DURCHLAUFERHITZER**

(71) Anmelder: Gerdes Holding GmbH & Co. KG, 21337 Lüneburg (DE)
(72) Erfinder: Bakhmetiev, Viktor, 21339 Lüneburg (DE); Cordes, Hans, 21394 Kirchgellersen (DE)
(74) Vertreter: Stork Bamberger Patentanwälte PartmbB

(57) **Zusammenfassung**

Die vorliegende Erfindung betrifft eine Anordnung zur lösbaren Befestigung einer gedruckten Schaltung an einer Montagebasis, umfassend die Montagebasis mit einem zur Aufnahme der gedruckten Schaltung eingerichteten Aufnahmeelement (10) sowie die gedruckte Schaltung mit einer Leiterplatte (11), wobei die Leiterplatte (11) mindestens eine zu mindestens einer ihrer Stirnseiten (12) hin offene Ausnehmung (14) unter Bildung eines federbeweglichen Rastelements (15) aufweist, und wobei das Rastelement (15) eingerichtet ist, die Leiterplatte (11) in einer Rastposition lösbar an dem Aufnahmeelement (10) zu arretieren. Des Weiteren betrifft die Erfindung eine Heizkartusche für einen Durchlauferhitzer.

## Beschreibung

Die Erfindung betrifft eine Anordnung zur lösbaren Befestigung einer gedruckten Schaltung an einer Montagebasis.

Um gedruckte Schaltungen an einer Montagebasis, beispielsweise einem Gehäuse oder Komponenten eines Gerätes lösbar zu befestigen, werden diese in der Regel mittels Schrauben oder Kunststoffclips lösbar angeordnet. Bekannt sind auch Schnapparretierungsmittel, die an der Montagebasis angeordnet sind und nach dem Einsetzen der gedruckten Schaltung deren Randbereiche übergreifen, um so die gedruckte Schaltung in der gewünschten Position zu arretieren.

Aus dem Stand der Technik sind darüber hinaus weitere Techniken zur Befestigung von gedruckten Schaltungen bzw. deren Leiterplatten bekannt. Aus dem Dokument WO 2007 036 181 A1 geht beispielsweise hervor, Leiterplatten mit mindestens einem Verbindungshaken oder mindestens einer Verbindungsausnehmung miteinander zu verbinden. Eine hierdurch entstehenden formschlüssige Verbindung beider Leiterplatten soll erhöhter mechanischer Belastung standhalten. Hierzu ist ein Verbindungshaken an einer Seite der ersten Leiterplatte angebracht und derart ausgebildet, dass er durch eine passende Verbindungsausnehmung in der zweiten Leiterplatte durchsteckbar ist. Zwischen dem Verbindungshaken und der ersten Leiterplatte ist ein Freiraum von in etwa der Dicke der zweiten Leiterplatte vorgesehen, wodurch beide Leiterplatten nach dem Durchstecken des Verbindungshakens durch die Verbindungsausnehmung relativ zueinander in gewissem Maß verschiebbar sind.

Aus dem Dokument KR 100 873 249 B1 ist eine Leiterplattenanordnung mit einer konkav-konvexen Verbindungsfläche bekannt. Zudem umfassen die Leiterplatten Kopplungselemente, bestehend aus einem elastischen Clip an einer der Leiterplatten und einem Halter mit einem zu den Maßen des Clips passenden Einlass für den Clip auf der jeweiligen anderen Leiterplatte.

Dokument WO 2018 118 238 A2 offenbart eine Leiterplatte mit einer Vielzahl von Ausschnitten entlang eines Teils der Leiterplattenkante, um mit korrespondierenden Ausschnitten einer weiteren Leiterplatte in einer gemeinsamen Ebene miteinander verbunden zu werden. Beide Leiterplatten sind sowohl elektrisch als auch mechanisch über diese Verbindung miteinander gekoppelt.

Im Dokument US 9 095 069 B2 werden Leiterplatten beschrieben, die an mindestens einem Randabschnitt fingerförmige Enden aufweisen, zwischen denen sich jeweils Ausnehmung befinden. In diese Ausnehmungen können Finger einer zweiten Leiterplatte formschlüssig eingeschoben werden. Entlang der Finger verlaufen Leiterbahnen, wodurch eine elektrische Verbindung zwischen den beiden Leiterplatten entsteht. Mechanisch werden die Leiterplatten durch Lötstellen dauerhaft zusammengehalten.

Nachteilig an den bekannten Lösungen ist, dass diese entweder nur das Verbinden von Leiterplatten untereinander ermöglichen oder aber zur Befestigung der Leiterplatten zusätzliche Bauteile benötigt werden.

Es ist daher Aufgabe der vorliegenden Erfindung eine Anordnung bereitzustellen, die eine möglichst einfache und komfortable, lösbare Befestigung eine Leiterplatte erlaubt. Es ist auch Aufgabe der vorliegenden Erfindung eine solche Anordnung bereitzustellen, die eine werkzeuglose Montage sowie Demontage einer Leiterplatte an der Montagebasis erlaubt.

Diese Aufgabe wird durch die eingangs genannte Anordnung gelöst, umfassend die Montagebasis mit einem zur Aufnahme der gedruckten Schaltung eingerichteten Aufnahmeelement sowie die gedruckte Schaltung mit einer Leiterplatte, wobei die Leiterplatte mindestens eine zu mindestens einer ihrer Stirnseiten hin offene Ausnehmung unter Bildung eines federbeweglichen Rastelements aufweist, und wobei das Rastelement eingerichtet ist, die Leiterplatte in einer Rastposition lösbar an dem Aufnahmeelement zu arretieren.

Die erfindungsgemäße Anordnung bietet den Vorteil, dass die Leiterplatte werkzeuglos an der Montagebasis montiert und ebenso wieder von dieser demontiert werden kann. Zudem sind keine separaten Befestigungsmittel erforderlich. Die Leiterplatte lässt sich so besonders einfach und komfortabel, insbesondere auch einhändig, an der Montagebasis anordnen und gegebenenfalls wieder von dieser lösen. Das federbewegliche Rastelement wird durch die zuvor beschriebene Ausnehmung der Leiterplatte gebildet.

Das Rastelement der Leiterplatte sowie das Aufnahmeelement der Montagebasis sind vorzugsweise derart korrespondierend zueinander in ihrer Geometrie ausgebildet, dass mittels des Rastelements die Leiterplatte an oder in dem Aufnahmeelement an der Montagebasisposition positionsfixiert anordenbar ist. Soll die Leiterplatte von der Montagebasis gelöst werden, kann dies durch leichten Druck auf das Rastelement erfolgen, sodass dieses ein Stück weit einfedert und sich die Leiterplatte von dem Aufnahmeelement lösen kann.

Eine bevorzugte Ausführungsform ist dadurch gekennzeichnet, dass sich die mindestens eine Ausnehmung zumindest im Wesentlichen parallel zu einer Längsseite der Leiterplatte erstreckt. Auf diese Weise wird eine hinreichende Federbeweglichkeit des Rastelements erzielt, sodass dieses einerseits mit nur geringem Kraftaufwand bei der Montage oder Demontage einfedert, aber zugleich die Leiterplatte an der Montagebasis zuverlässig arretiert.

Eine vorteilhafte Weiterbildung zeichnet sich dadurch aus, dass ein freier Schenkel des Rastelements eine an der Längsseite nach außen hervorragende Rastnase aufweist, die eingerichtet ist, in der Rastposition das Aufnahmeelement oder eine Gegenlage des Aufnahmeelements unter Arretierung des Rastelements an dem Aufnahmeelement zu hinterschneiden. Dies bietet den Vorteil, dass die Leiterplatte in der Rastposition zuverlässig an dem Aufnahmeelement der Montagebasis arretiert ist und auf diese Weise gegen unbeabsichtigtes Lösen gesichert ist. Anders ausgedrückt steht die Rastnase gegenüber der genannten Längsseite ein wenig vor, sodass diese in der Rastposition das Aufnahmeelement arretierend hintergreift.

In einer weiteren vorteilhaften Ausgestaltung der Erfindung ist die mindestens eine Ausnehmung zu der mindestens einen Stirnseite hin sich verbreiternd ausgebildet. Vorteilhafterweise wird so zusätzlich Raum geschaffen, in den das Rastelement im eingefederten Zustand hingedrängt wird. So wird sichergestellt, dass das Rastelement mit der Rastnase hinreichend weit genug einfedern kann, um die Verrastung mit dem Aufnahmeelement zum Lösen der Leiterplatte vollständig aufzuheben.

Eine zweckmäßige Ausgestaltung der Erfindung ist dadurch gekennzeichnet, dass das Aufnahmeelement eine Durchführungsausnehmung mit zwei Gleitkanten aufweist, die eingerichtet sind, die Längsseiten der Leiterplatte beim Einschieben der Leiterplatte in die Rastposition gleitend zu führen. Mit anderen Worten ist das Aufnahmeelement ausgebildet, die Leiterplatte an ihren Längsseiten zu führen. Auf diese Weise ist die Leiterplatte auf besonders einfache und komfortable Weise in die Durchführungsausnehmung einsteckbar eingerichtet.

Gemäß einer weiteren bevorzugten Ausführungsform der Erfindung entspricht die lichte Weite der Durchführungsausnehmung mindestens der Breite der Leiterplatte zwischen den Längsseiten. Dies bietet den Vorteil, dass die Leiterplatte weitestgehend kräftefrei in die Überführungsausnehmung eingeführt werden kann, während diese mittels der Durchführungsausnehmung präzise geführt wird. Die Montage bzw. Demontage der Leiterplatte kann auf diese Weise besonders leicht erfolgen, ohne dass dabei Abstriche im Hinblick auf eine sichere Arretierung in der Rastposition gemacht werden müssen.

Eine zweckmäßige Ausgestaltung der Erfindung ist dadurch gekennzeichnet, dass Endbereiche der mindestens einen Ausnehmung eine Krümmung aufweisen, die von dem Rastelement weg gerichtet ist. Anders ausgedrückt sind die Endbereiche der Ausnehmung abgerundet ausgebildet und eingerichtet.

Eine bevorzugte Weiterbildung der Erfindung zeichnet sich dadurch aus, dass das Aufnahmeelement ein Einschubbegrenzungselement aufweist, das eingerichtet ist, mit der Leiterplatte in der Rastposition unter Begrenzung der Einschubtiefe der Leiterplatte in Kontaktanlage zu gelangen. Hierdurch wird stets eine exakte Positionierung der Leiterplatte in der Rastposition gewährleistet, in dem die Einschubtiefe mittels des Einschubbegrenzungselements limitiert wird.

Eine zweckmäßige Ausgestaltung der Erfindung ist dadurch gekennzeichnet, dass das Rastelement ein an der Längsseite nach außen hervorragendes Gleitelement umfasst, dessen Breite geringer als die der Rastnase ist. Hierdurch wird die Kontaktfläche zwischen der Längsseite und der Durchgangsausnehmung minimiert. Auf diese Weise ist die Leiterplatte in der Durchgangsausnehmung mit nur geringem Kraftaufwand in die Rastposition einschiebbar eingerichtet.

Eine vorteilhafte Weiterbildung zeichnet sich dadurch aus, dass die Leiterplatte einstückig ausgebildet ist. Die Einstückigkeit bietet den Vorteil, dass keine - andernfalls zur Befestigung der Leiterplatte an der Montagebasis erforderlichen - separaten Befestigungsmittel abhandenkommen können. Die Leiterplatte in ihrer einstückigen Form bringt alle erforderlichen Mittel mit, um die zuvor beschriebene Arretierfunktion an der Montagebasis zu gewährleisten.

In einer bevorzugten Weiterbildung der Erfindung umfasst die Leiterplatte verstärkte Epoxidharzsubstrate oder Glasfasern und Epoxidharzsubstrate. Hierdurch wird einerseits die erforderliche Festigkeit der Leiterplatte als Trägerelement für elektronische Bauelemente erzielt und zugleich die für die Federwirkung des Rastelements erforderliche Elastizität des Leiterplattenmaterials bereitgestellt.

Des Weiteren wird die Aufgabe durch die eingangs genannte Heizkartusche für einen Durchlauferhitzer gelöst, indem die Heizkartusche eine Anordnung mit den vorgenannten Merkmalen umfasst, wobei die Heizkartusche das Aufnahmeelement umfasst. Vorteilhafterweise ist es so möglich, die Leiterplatte auf besonders einfache und komfortable Weise direkt an der Heizkartusche eines Durchlaufnetzes anzuordnen. Die Heizkartusche dient dabei als Montagebasis.

Eine weitere zweckmäßige Ausgestaltung der Erfindung ist dadurch gekennzeichnet, dass die gedruckte Schaltung als Durchflussmessgeber ausgebildet ist, um den Volumenstrom des zu erwärmenden Mediums in der Heizkartusche zu erfassen. Bei elektronischen Durchlauferhitzern ist es regelmäßig erforderlich, den im Betrieb in der Heizkartusche herrschenden Volumenstrom zu erfassen. Zur Erfassung des Volumenstroms ist daher die gedruckte Schaltung unmittelbar an der Heizkartusche anzuordnen. Ein solcher Durchflussmessgeber weist beispielsweise ein im Strömungsweg der Heizkartusche angeordnetes Flügelrad auf, das mit Dauermagneten ausgestattet ist. Mittels eines Hall-Sensors kann die Umdrehungszahl elektronisch erfasst und zur Bestimmung des tatsächlichen Durchflusses ausgewertet werden.

Erfindungsgemäß wird die gedruckte Schaltung hierzu auf besonders einfache Art und Weise unmittelbar an der Heizkartusche im Bereich des Flügelrades außen angeordnet. Damit wird der Fertigungsprozess wesentlich vereinfacht. Zudem ist es möglich, zu Wartungs- und/oder Reparaturzwecken die gedruckte Schaltung des Durchflussmengengebers mit wenigen Handgriffen von der Heizkartusche lösen zu können.

Weitere zweckmäßige und/oder vorteilhafte Merkmale und Weiterbildungen ergeben sich aus den Unteransprüchen und der Beschreibung. Besonders bevorzugte

Ausführungsformen der erfindungsgemäßen Anordnung sowie der erfindungsgemäßen Heizkartusche werden anhand der beigefügten Zeichnungen näher erläutert. In den Zeichnungen zeigen:
- Fig. 1: eine schematische Darstellung der erfindungsgemäßen Leiterplatte in nicht eingerasteter Position,
- Fig. 2: eine schematische Darstellung der erfindungsgemäßen Leiterplatte in der Rastposition,
- Fig. 3: eine schematische Darstellung von Leiterplatte und Aufnahmeelement in der Rastposition,
- Fig. 4: eine schematische Darstellung der erfindungsgemäßen Leiterplatte beim Einschieben in die Durchgangsausnehmung,
- Fig. 5: eine Heizkartusche mit der erfindungsgemäßen Anordnung in perspektivischer Ansicht und
- Fig. 6: die in Figur 5 gezeigte Heizkartusche mit der erfindungsgemäßen Anordnung in Draufsicht.

Anhand der vorgenannten Figuren wird die erfindungsgemäße Anordnung sowie die erfindungsgemäße Heizkartusche im Folgenden näher beschrieben.

Die erfindungsgemäße Anordnung umfasst eine - in der Zeichnung nicht gezeigte - Montagebasis. Eine solche Montagebasis kann beispielsweise eine Heizkartusche eines Durchlauferhitzers, ein Gehäuse, eine Gerätegrundplatte oder dergleichen sein.

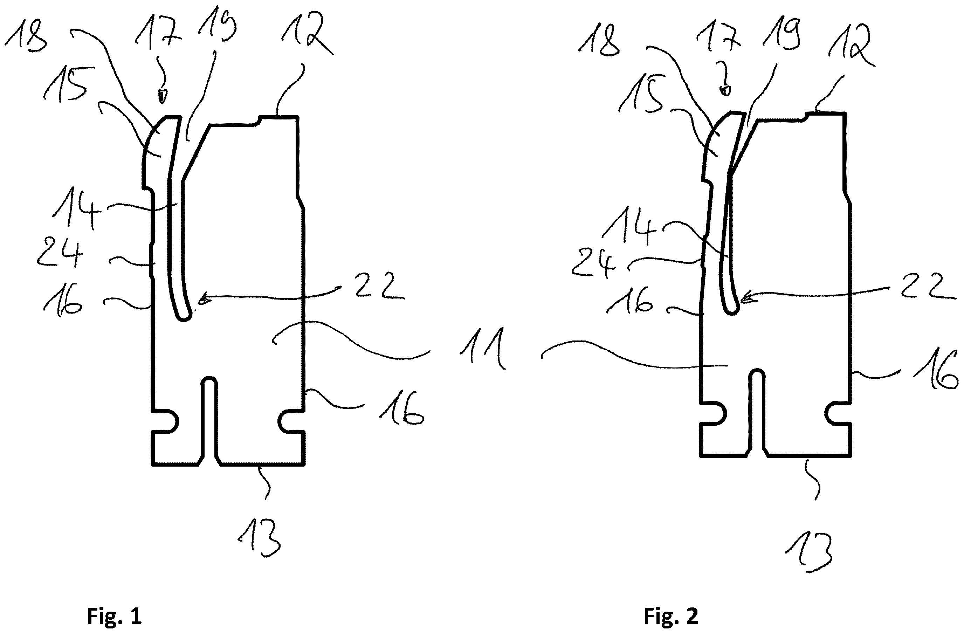

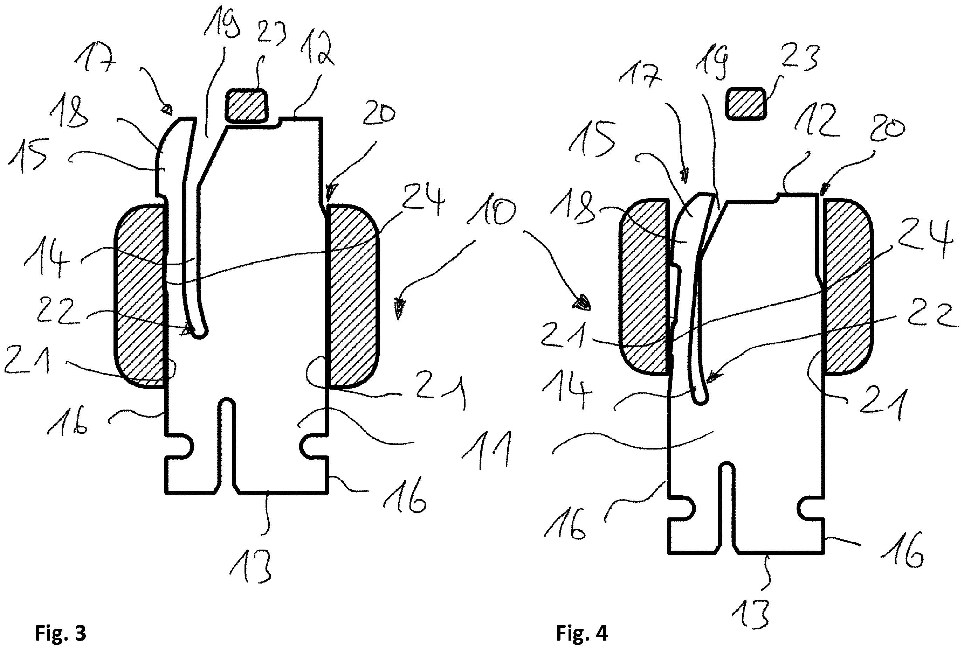

Wie in den Figuren 3 und 4 gezeigt, umfasst die Anordnung weiter ein Aufnahmeelement 10, das zur Aufnahme einer gedruckten Schaltung eingerichtet ist. Die erfindungsgemäße Anordnung umfasst zudem die gedruckte Schaltung mit einer Leiterplatte 11. Die Leiterplatte 11 weist mindestens eine zu mindestens einer ihrer Stirnseiten 12, 13 hin offene Ausnehmung 14 auf. Diese Ausnehmung 14 in der Leiterplatte 11 bildet ein federbewegliches Rastelement 15. Das Rastelement 15 ist eingerichtet, die Leiterplatte - in den in den Figuren 1 und 3 gezeigten Rastpositionen - lösbar an dem Aufnahmeelement 10 zu arretieren.

Wie in der Zeichnung gezeigt, erstreckt sich die mindestens eine Ausnehmung 14 zumindest im Wesentlichen parallel zu einer Längsseite 16 der Leiterplatte 11. Die Ausnehmung 14 ist also entweder exakt parallel zu der Längsseite 16 oder geringfügig davon abweichend ausgerichtet. Vorzugsweise bildet die Ausnehmung 14 einen Längsschlitz, der sich weiter bevorzugt über mindestens die Hälfte der Länge der Längsseite 16 erstreckt.

Vorzugweise weist ein freier Schenkel 17 des Rastelements 15 eine an der Längsseite 16 nach außen hervorragende Rastnase 18 auf. Die Rastnase 18 ist eingerichtet, in der - in den Figuren 1 und 3 gezeigten - Rastposition das Aufnahmeelement 10 oder eine Gegenlage des Aufnahmeelements 10 unter Arretierung des Rastelements 15 an dem Aufnahmeelement 10 zu hinterschneiden. Mit anderen Worten ist die Rastnase 18 derart ausgebildet, dass diese zumindest einen Teil des Aufnahmeelements 10 in der Rastposition hintergreift. Auf diese Weise ist die Leiterplatte 11 sicher an dem Aufnahmeelement 10 arretiert, kann jedoch bei Bedarf durch Einfedern des Rastelements 15 wieder von dem Aufnahmeelement 10 gelöst werden.

Vorteilhafterweise ist die mindestens eine Ausnehmung 14 zu der mindestens einen Stirnseite 12 hin sich verbreiternd ausgebildet. Hierdurch entsteht ein Aufnahmeraum 19, in den das Rastelement 15 ausweichen kann, wenn sich dieses unter Kraftbeaufschlagung federnd bewegt.

Das Aufnahmeelement 10 weist vorzugsweise eine Durchführungsausnehmung 20 mit zwei Gleitkanten 21 auf. Die Gleitkanten 21 sind ausgebildet, die Längsseiten 16 der Leiterplatte 11 beim Einschieben der Leiterplatte 11 in die Rastposition und umgekehrt gleitend zu führen.

Bevorzugt entspricht die lichte Weite der Durchführungsausnehmung 20 mindestens der Breite der Leiterplatte 11 zwischen den Längsseiten 16, um die Leiterplatte 11 möglichst leichtgängig in die Durchführungsausnehmung 20 einbringen bzw. diese wieder entfernen zu können.

Weiter bevorzugt weisen Endbereiche 22 der mindestens einen Ausnehmung 14 eine Krümmung auf, die von dem Rastelement 15 weg gerichtet ist bzw. sind. An diesen Endbereichen 22 ist das Rastelement 15 gegenüber den restlichen Bereichen des Rastelements 15 breiter ausgebildet. Durch die Wahl des Krümmungsgrades kann die Materialstegbreite des Rastelements 15 in den Endbereichen 22 vorgegeben und damit die Federkonstante des Rastelements 15 an die jeweiligen Bedürfnisse optimal angepasst werden.

Die erfindungsgemäße Anordnung umfasst vorzugsweise ein Einschubbegrenzungselement 23. Das Einschubbegrenzungselement 23 ist vorzugsweise Teil des Aufnahmeelements 10. Das Einschubbegrenzungselement 23 ist eingerichtet, mit der Leiterplatte in der Rastposition unter Begrenzung der Einschubtiefe der Leiterplatte 11 in Kontaktanlage zu gelangen (vgl. Fig. 3).

Bevorzugt umfasst das Rastelement 15 ein an der Längsseite nach außen hervorragendes Gleitelement 24, dessen Breite geringer, als die Breite der Rastnase 18 ist. Das Gleitelement 24 wird also insbesondere durch einen Vorsprung an der Längsseite des Rastelements 15 gebildet.

Die Leiterplatte 11 ist insbesondere einstückig ausgebildet. Die Ausnehmung 14 wird beispielsweise durch Fräsung hergestellt. Vorzugsweise besteht die Leiterplatte 11 aus verstärktem Epoxidharzsubstrat oder Glasfasern und Epoxidharzsubstrat.

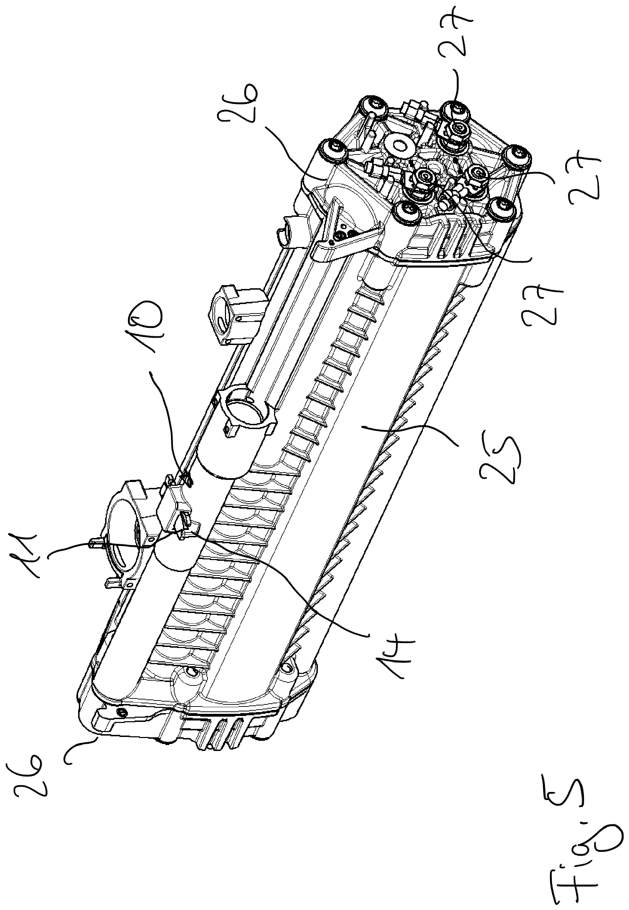

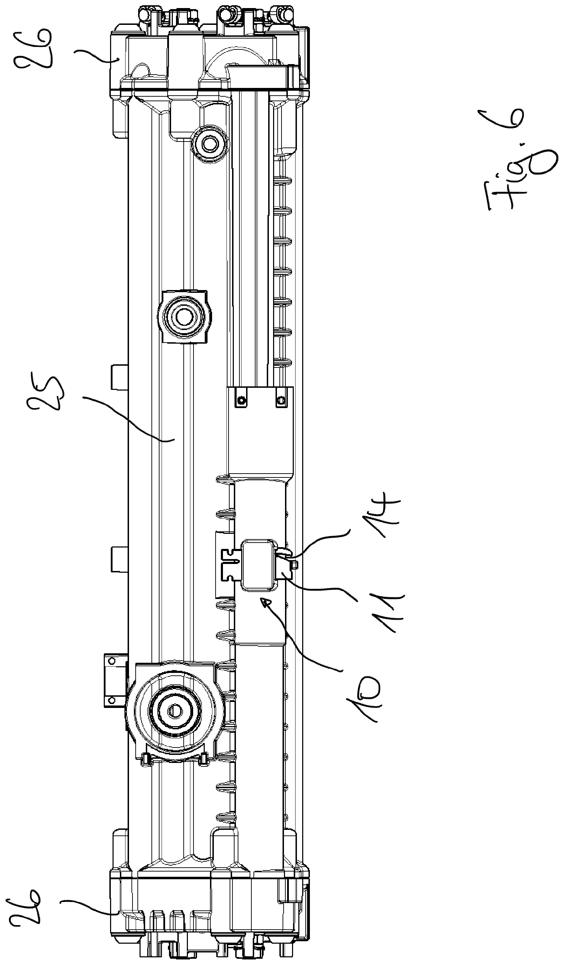

Die vorliegende Erfindung umfasst auch die eingangs genannte Heizkartusche für einen Durchlauferhitzer. Eine solche Heizkartusche ist in den Figuren 5 und 6 schematisch dargestellt. Die Heizkartusche umfasst dabei die zuvor beschriebene erfindungsgemäße Anordnung, wobei die Heizkartusche selbst das Aufnahmeelement 10 umfasst. Beispielsweise ist die Heizkartusche als Kunststoffspritzgusskörper ausgebildet in die das Aufnahmeelement 10 integriert ist.

Weiter bevorzugt zeichnet sich die erfindungsgemäße Heizkartusche dadurch aus, dass die gedruckte Schaltung als Durchflussmessgeber ausgebildet ist, um den Volumenstrom des zu erwärmenden Mediums in der Heizkartusche zu erfassen.

Die Heizkartusche weist vorzugsweise einen Grundkörper 25 sowie Stirnseitenelemente 26 auf, die eine fluiddichte Kanalanordnung bilden. Die Kanalanordnung umfasst mindestens einen Heizkanal, in dem jeweils ein Blankdrahtheizelement angeordnet ist. Elektrische Kontaktelemente 27 sind durch mindestens eines der Stirnseitenelemente 26 geführt, über die zum Betrieb der Blankdrahtheizelemente erforderliche Versorgungsspannung bereitgestellt wird.

## Patentansprüche

1. Anordnung zur lösbaren Befestigung einer gedruckten Schaltung an einer Montagebasis, umfassend
die Montagebasis mit einem zur Aufnahme der gedruckten Schaltung eingerichteten Aufnahmeelement (10) sowie die gedruckte Schaltung mit einer Leiterplatte (11), wobei
die Leiterplatte (11) mindestens eine zu mindestens einer ihrer Stirnseiten (12) hin offene Ausnehmung (14) unter Bildung eines federbeweglichen Rastelements (15) aufweist, und wobei
das Rastelement (15) eingerichtet ist, die Leiterplatte (11) in einer Rastposition lösbar an dem Aufnahmeelement (10) zu arretieren.

2. Anordnung nach Anspruch 1, **dadurch gekennzeichnet, dass** sich die mindestens eine Ausnehmung (14) zumindest im Wesentlichen parallel zu einer Längsseite (16) der Leiterplatte (11) erstreckt.

3. Anordnung nach Anspruch 2, **dadurch gekennzeichnet, dass** ein freier Schenkel (17) des Rastelements (15) eine an der Längsseite (16) nach außen hervorragende Rastnase (18) aufweist, die eingerichtet ist, in der Rastposition das Aufnahmeelement (10) oder eine Gegenlage des Aufnahmeelements (10) unter Arretierung des Rastelements (15) an dem Aufnahmeelement (10) zu hinterschneiden.

4. Anordnung nach Anspruch 3, **dadurch gekennzeichnet, dass** die mindestens eine Ausnehmung (14) zu der mindestens einen Stirnseite (12) hin sich verbreiternd ausgebildet ist.

5. Anordnung nach einem der Ansprüche 1 bis 4, **dadurch gekennzeichnet, dass** das Aufnahmeelement (10) eine Durchführungsausnehmung (20) mit zwei Gleitkanten (21) aufweist, die eingerichtet sind, die Längsseiten (16) der Leiterplatte (11) beim Einschieben der Leiterplatte (11) in die Rastposition gleitend zu führen.

6. Anordnung nach Anspruch 5, **dadurch gekennzeichnet, dass** die lichte Weite der Durchführungsausnehmung (20) mindestens der Breite der Leiterplatte (11) zwischen den Längsseiten (16) entspricht.

7. Anordnung nach einem der Ansprüche 1 bis 6, **dadurch gekennzeichnet, dass** Endbereiche (22) der mindestens einen Ausnehmung (14) eine Krümmung aufweisen, die von dem Rastelement (15) weg gerichtet sind.

8. Anordnung nach einem der Ansprüche 1 bis 7, **dadurch gekennzeichnet, dass** das Aufnahmeelement (10) ein Einschubbegrenzungselement (23) aufweist, das eingerichtet ist, mit der Leiterplatte (11) in der Rastposition unter Begrenzung der Einschubtiefe der Leiterplatte (11) in Kontaktanlage zu gelangen.

9. Anordnung nach einem der Ansprüche 3 bis 8, **dadurch gekennzeichnet, dass** das Rastelement (15) ein an der Längsseite (16) nach außen hervorragendes Gleitelement (24) umfasst, dessen Breite geringer als die der Rastnase (18) ist.

10. Anordnung nach einem der Ansprüche 1 bis 9, **dadurch gekennzeichnet, dass** die Leiterplatte (11) einstückig ausgebildet ist.

11. Anordnung nach einem der Ansprüche 1 bis 10, **dadurch gekennzeichnet, dass** die Leiterplatte (11) verstärkte Epoxidharzsubstrate oder Glasfasern und Epoxidharzsubstrate umfasst.

12. Heizkartusche für einen Durchlauferhitzer, **dadurch gekennzeichnet, dass** die Heizkartusche eine Anordnung nach einem der Ansprüche 1 bis 11 umfasst, wobei die Heizkartusche das Aufnahmeelement (11) umfasst.

13. Heizkartusche nach Anspruch 12, **dadurch gekennzeichnet, dass** die gedruckte Schaltung als Durchflussmessgeber ausgebildet ist, um den Volumenstrom des zu erwärmenden Mediums in der Heizkartusche zu erfassen.
